(19) Europäisches Patentamt
European Patent Office
Office européen des brevets

(11) **EP 3 343 651 B1**

(12) **EUROPEAN PATENT SPECIFICATION**

(45) Date of publication and mention of the grant of the patent:
**18.09.2019 Bulletin 2019/38**

(21) Application number: **16851408.1**

(22) Date of filing: **26.09.2016**

(51) Int Cl.:
*H01L 35/26* (2006.01)  *B82Y 30/00* (2011.01)
*B82Y 40/00* (2011.01)  *C01B 33/02* (2006.01)
*H01L 29/06* (2006.01)  *H01L 35/34* (2006.01)

(86) International application number:
**PCT/JP2016/078191**

(87) International publication number:
**WO 2017/057237 (06.04.2017 Gazette 2017/14)**

(54) **THERMOELECTRIC CONVERSION MATERIAL AND METHOD FOR PRODUCING SAME**

THERMOELEKTRISCHES UMWANDLUNGSMATERIAL UND VERFAHREN ZUR HERSTELLUNG DAVON

MATÉRIAU DE CONVERSION THERMOÉLECTRIQUE ET SON PROCÉDÉ DE PRODUCTION

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **02.10.2015 JP 2015196414**

(43) Date of publication of application:
**04.07.2018 Bulletin 2018/27**

(73) Proprietors:
• **Central Glass Company, Limited**
  **Yamaguchi 755-0001 (JP)**
• **Tohoku Techno Arch Co., Ltd.**
  **Sendai-shi, Miyagi 980-0845 (JP)**

(72) Inventors:
• **KIKUCHI Akiou**
  **Ube City**
  **Yamaguchi 755-0001 (JP)**
• **YAO Akifumi**
  **Ube City**
  **Yamaguchi 755-0001 (JP)**
• **SAMUKAWA Seiji**
  **Sendai-shi**
  **Miyagi 980-8577 (JP)**
• **ONO Takahito**
  **Sendai-shi**
  **Miyagi 980-8577 (JP)**

(74) Representative: **dompatent von Kreisler Selting Werner - Partnerschaft von Patent- und Rechtsanwälten mbB**
**Deichmannhaus am Dom**
**Bahnhofsvorplatz 1**
**50667 Köln (DE)**

(56) References cited:
**JP-A- H05 251 338**   **JP-A- 2003 218 346**
**JP-A- 2004 193 526**  **JP-A- 2005 022 077**
**JP-A- 2005 022 077**  **JP-A- 2008 523 579**
**JP-A- 2013 545 102**  **JP-A- 2015 103 609**
**KR-A- 20130 099 752**  **US-A1- 2002 026 856**
**US-A1- 2006 032 526**  **US-A1- 2010 170 552**

## Description

## TECHNICAL FIELD

The present invention relates to a silicon-based thermoelectric conversion material used in a thermoelectric conversion device.

## BACKGROUND ART

Thermoelectric conversion devices can directly convert thermal energy into electric energy and have no movable member present, in contrast to conventional power generation technologies. For this reason, thermoelectric conversion devices have a lot of merits that they are maintenance-free, have long life and do not generate noise, and further, low-temperature waste heat can be utilized.

The performance of a thermoelectric conversion material is, in general, expressed by the dimensionless figure of merit (ZT). That is, a material having high ZT is a material having high Seebeck coefficient and electric conductivity and having low thermal conductivity.

[Numerical formula 1]

$$ZT = \frac{S^2 \sigma}{\kappa_e + \kappa_{ph}} T$$

S: Seebeck coefficient (V/K)
$\sigma$: electric conductivity (S/m)
$\kappa_e$: carrier thermal conductivity (W/m·K)
$\kappa_{ph}$: lattice thermal conductivity (W/m·K)
T: absolute temperature (T)

The value of the ZT varies depending on the material and the temperature. $Bi_2Te_3$ currently used as a thermoelectric conversion material has a dimensionless figure of merit ZT of about 0.8 in a range of relatively low temperatures of 100 to 300°C. The currently used thermoelectric conversion material, however, is mainly composed of Bi, Sb, Te and Pb as rare metals. The deposits of these stocks are small, thus, the material cost thereof is high. Further, these thermoelectric conversion materials have a short life as the device because of tendency of oxidation at high temperatures of 300 to 400°C, and further have a possibility of toxicity.

Accordingly, it has been investigated whether ZT equivalent to the BiTe-based material can be obtained by a Si-based material needing lower cost and having lower toxicity as compared the BiTe-based material. The Si-based material has ZT which is lower remarkably than that of the BiTe-based material since the lattice thermal conductivity of the Si-based material is higher about 100 times in comparison with BiTe. Because of this reason, use of the Si-based material as a thermoelectric conversion material is believed to be difficult. However, it has recently been discovered that the lattice thermal conductivity of a Si-based material generating phonon scattering by nanostructuring of the material can be reduced as compared with a bulk body of the Si-based material. Resultantly, a thermoelectric conversion device using nanostructured Si is drawing attention.

For example, Patent Document 1 discloses a technology for reduction of thermal conductivity and accompanying improvement of the property (thermoelectric figure of merit) of a thermoelectric conversion device, by introducing a lot of very fine vacancies dispersed at an interval equivalent to or smaller than the mean free path of electrons and phonons into the semiconductor material. Further, it is also possible to improve the thermoelectric performance by filling another semiconductor or a metal into fine vacancies. As the method of forming the fine vacancies, an electrochemical reaction (for example, anodic reaction) is used, and for filling another semiconductor or a metal, a method of immersing into a melted semiconductor or metal is used.

In Non-Patent Document 1, nanostructuring of Si by means of top down using electron beam lithography is tried, and a method of forming a thermoelectric conversion device having a structure consisting of a Si nanowire having a diameter of tens of nm and $SiO_2$ coating the outer peripheral part thereof is disclosed.

In addition, Patent Document 2 discloses a method of forming a quantum dot by a bio-template technology and a neutral particle beam etching technology. As development of its use, a solar battery and laser are described. As the quantum dot to be formed, Si and GaAs are disclosed, and as the embedding material, SiC, $SiO_2$, $(Si_3N_4)$ and the like are disclosed.

Patent Document 3 discloses a substrate with columnar nanodots (nanowires). The average diameter of the nanowire is 0.5-15nm. The spacing between the nanodots is 5-20nm. The nanodots are made of a BiTe material.

Patent Document 4 discloses discloses SiGe nanoparticles embedded in a matrix and the band edge gap can be 0.1eV or less.

Patent Document 5 discloses a method of forming nanodots in a substrate by using a lithographic subtractive technique using a mask. The distance between the nanodots formed is minimal 50nm.

Patent Document 6 discloses forming an array of metal particles by using a self aligning assembly of proteins with a metal.

## CITATION LIST

PATENT LITERATURE

Patent Document 1: Japanese Patent Application Laid-Open No. H11-317547
Patent Document 2: International Publication WO2012/173162
Patent Document 3: US 2006/032526 A1
Patent Document 4: JP 2008 523579 A
Patent Document 5: JP H05 251338 A
Patent Document 6: JP 2015 103609 A

NON-PATENT LITERATURE

Non-Patent Document 1: Benjamin. M. C. et al., Nano let. 13(2013) 5503

**SUMMARY OF INVENTION**

**TECHNICAL PROBLEM**

In the method of the invention described in Patent Document 1, a silicon substrate is made into porous and an effect of reducing thermal conductivity can be expected, however, lowering of Seebeck coefficient due to lowering of electron mobility becomes remarkable simultaneously. Though it is necessary to control pore diameter, density and the like for this reason, they cannot be controlled easily by disclosed means (such as anodization) and the improvement of the thermoelectric property is limited. There is also disclosed a method of filling a BiTe-based material into pores (vacancies) as the means for improving ZT, however, it is difficult to fill a material having melting point equivalent to that of a silicon substrate forming pores into the pore. Therefore, the method of the invention described in Patent Document 1 cannot solve the problem of use of rare metals.

The method described in Non-Patent Document 1 uses a means combining a current lithography technology (electron beam lithography) and top down (ICP plasma etching). By this means, control of pore diameter and density which is the problem in Patent Document 1 is made possible. However, there is a problem that it is difficult to form a structure having a size of 20 nm or less, such a structure being believed to be necessary for reducing the lattice thermal conductivity of silicon, since formation of a nanostructure having a size of about tens of nm is boundary according to the current lithography technology.

Further, the two-dimensional quantum nanodot array using a material of a quantum dot and an embedding material described in Patent Document 2 cannot manifest an excellent thermoelectric conversion performance since a difference in energy between the valence bands or the conduction bands of SiC and SiN disclosed as the embedding material with respect to Si used as the dot formation material (namely, a different in energy between the valence band of the dot formation material and the valence band of the embedding material, or a difference in energy between the conduction band of the dot formation material and the conduction band of the embedding material) is large. Group III-V semiconductors such as GaAs have a problem of high toxicity.

The present invention is made for solving the problems of conventional technologies as described above, and has an object of obtaining a thermoelectric conversion material manifesting an excellent thermoelectric conversion performance, using a silicon-based material.

**SOLUTION TO PROBLEMS**

The present inventors have intensively studied and resultantly found that a high performance thermoelectric conversion material using a silicon-based material is obtained by processing the silicon-based material into nanodots having a size of 20 nm or less and by filling the embedding material between the dots, wherein either one or both of a difference in energy between the valence band of the silicon-based material constituting the nanodot and the valence band of the embedding material and a difference in energy between the conduction band of the silicon-based material constituting the nanodot and the conduction band of the embedding material are in the range of 0.1 eV or more and 0.3 eV or less, leading to completion of the present invention.

Specifically, the present invention according to claim 1 provides the following:

A thermoelectric conversion material characterized in that columnar or spherical nanodots having a diameter of 20 nm or less are embedded in an embedding layer at an area density of $5 \times 10^{10}/cm^2$ or more and an interval between the nanodots of 0.5 nm or more and 30.0 nm or less, and the first material constituting the nanodot is a material containing silicon in an amount of 30 atom% or more, and, either one or both of a difference in energy between the valence band of the first material and the valence band of the second material constituting the embedding layer and a difference in energy between the conduction band of the first material and the conduction band of the second material constituting the embedding layer are in the range of 0.1 eV or more and 0.3 eV or less.

The present invention according to claim 3 provides further a production method of the thermoelectric conversion material according to Invention 1, characterized by comprising a step of arraying nanoparticles having a diameter of 1 nm or more and 20 nm or less on a semiconductor layer, a step of forming a columnar or spherical nanodot having a diameter of 20 nm or less by etching the semiconductor layer utilizing the nanoparticles as a mask, and a step of forming an embedding layer so as to embed the nanodot.

A production method of the thermoelectric conversion material according to Claim 1, characterized by comprising a step of arraying protein particles containing a metal on a semiconductor layer, a step of forming a metal compound particle by removing a protein from the protein particle, a step of forming a columnar or spherical nanodot having a diameter of 20 nm or less by etching the semiconductor layer utilizing the metal compound particles as a mask, a step of removing the metal compound particles, and a step of forming an embedding layer so as to embed the nanodot.

## ADVANTAGEOUS EFFECTS OF INVENTION

According to the present invention, it becomes possible to form a high performance thermoelectric conversion material using a silicon-based material, since a lowering in Seebeck coefficient generating in nanostructuring a silicon-based material which is currently problematic is made solvable by the present invention.

## BRIEF DESCRIPTION OF DRAWINGS

Fig. 1 is a schematic view of the thermoelectric conversion material 5 according to the present invention.
Fig. 2 is a view showing a production method of a thermoelectric conversion material according to the present invention.
Fig. 3 is a view showing another example of the production method of a thermoelectric conversion material according to the present invention.
Fig. 4 shows scanning electron microscopic images of a thermoelectric conversion material according to Example 1.
Fig. 5 shows scanning electron microscopic images of the thermoelectric conversion material according to Example 1.
Fig. 6 is a view showing thermoelectric conversion properties of examples and comparative examples.
Fig. 7(a) is a view showing the band structure of the junction plane of Si and $Si_{0.7}Ge_{0.3}$, and Fig. 7(b) is a view showing the band structure of the junction plane of Si and SiC.

## DESCRIPTION OF EMBODIMENTS

The present invention will be explained below.

<Thermoelectric conversion material>

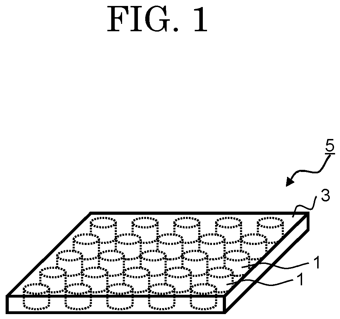

The thermoelectric conversion material of the present invention has a constitution in which columnar or spherical nanodots 1 having a diameter of 20 nm or less are embedded in an embedding layer 3 at an area density of $5\times10^{10}$/cm$^2$ or more and an interval between the nanodots of 0.5 nm or more and 30.0 nm or less, as shown in Fig. 1(a).
The nanodot has a size of 20 nm or less in which the diameter in the two-dimensional direction in which the embedding layer spreads. When the diameters of the nanodots are measured by an electron microscope and distribution thereof is determined, it is preferable that 90% or more nanodots on a number basis are included in the range of a diameter of 8 ± 5 nm. The nanodot has a thickness of several nm to tens of nm, and may be columnar or spherical, and may also be conical depending on the case.
The interval between the nanodots is 0.5 nm or more and 30.0 nm or less, preferably 0.5 nm or more and 7.0 nm or less. The interval between the nanodots denotes a distance between the outermost surface of a certain nanodot and the outermost surface of the nearest adjacent nanodot.
The area density of the nanodot is determined by the diameter of the nanodot and the interval between the dots, and is $5\times10^{10}$/cm$^2$ or more, preferably $1\times10^{11}$/cm$^2$ or more, more preferably $5\times10^{11}$/cm$^2$ or more and $8\times10^{11}$/cm$^2$ or less. Regarding the upper limit of the area density, the calculated coverage rate is about 90% in the case of closest-packing (for example, a coverage rate of 90% corresponds to $8.1\times10^{11}$/cm$^2$ when the dot size is 13 nm.). While one layer of the periodic structure of nanodots is contained in the embedding layer in Fig. 1, several periodic structures of nanodots may be laminated and contained in the embedding layer. In this case, the area density is determined for nanodots arrayed two-dimensionally in the embedding layer, and when several arrays of nanodots are laminated in the embedding layer, the area density is determined for one layer of them.
By having the periodic structure of nanodots in the embedding layer, phonon scattering occurs at the interface of nanodots and the embedding layer, and it becomes possible to reduce the lattice thermal conductivity of a thermoelectric conversion material.
The first material constituting the nanodot is a material containing silicon in an amount of 30 atom% or more, and a difference in energy between the valence band of the first material and the valence band of the second material constituting the embedding layer or a difference in energy between the conduction band of the first material and the conduction band of the second material constituting the embedding layer is in the range of 0.1 eV or more and 0.3 eV or less.
This makes it possible to form an intermediate band between nanodots and the embedding layer, and there occurs an energy filtering effect in which when carriers accumulated in the embedding layer are transported in the nanodot array, the nanodot array structure constitutes a potential barrier, and low energy carrier components are not transmitted. By this, the spectrum conductivity near the band gap can be controlled, to improve Seebeck coefficient.
It is preferable that the combination of the first material and the second material is a combination of silicon and silicongermanium. By combining these materials, the first material can be etched by neutral particle beam etching without imparting damages, and since the first material and the second material have a suitable difference in the band gap, an intermediate band can be formed between nanodots and the embedding layer. Further, the first material and the second material are each inexpensive and available easily, and a film formation method thereof is also established.

In this constitution, silicon may be monocrystalline silicon or polycrystalline silicon, and may be doped or may not be doped.

Silicongermanium is a semiconductor obtained by adding germanium to silicon, and in the present invention, the content of germanium in silicongermanium is 20 mol% or more and 80 mol% or less, that is, the molar ratio of silicon to germanium is 20:80 to 80:20. The melting point of silicongermanium is $1139 - 738x + 263x^2$ (x: Si molar concentration, $0.2 \leq x \leq 0.8$) K, and silicongermanium is known as a thermoelectric conversion material showing high conversion efficiency under high temperature environment (around 600 to 800 K).

The band gap of silicon is 1.1 eV in the case of monocrystal and about 1.5 eV in the case of polycrystal, in contrast, the band gap of silicongermanium (for example, $Si_{0.7}Ge_{0.3}$) is $1.12 - 0.41x + 0.0008x^2$ (x: Si molar concentration, $0.2 \leq x \leq 0.8$) eV, and when silicon is used as the dot forming material and silicongermanium (for example, $Si_{0.7}Ge_{0.3}$) is used as the embedding material, band offset of $\Delta Ev = 0.26$ eV occurs at the valence band side. That is, a difference in energy between the valence band of silicon and the valence band of $Si_{0.7}Ge_{0.3}$ is 0.26 eV.

The thermoelectric conversion material of the present invention is cheaper, is not restricted in its stock and has lower toxicity as compared with conventional BiTe-based materials since a silicon-based material is used in the thermoelectric conversion material of the present invention. Further, the thermoelectric conversion material of the present invention has excellent thermoelectric figure of merit since a nanostructured silicon-based material is embedded with a prescribed material.

<Production method of thermoelectric conversion material>

Next, the production process of a thermoelectric conversion material of the present invention will be explained. In the present invention, a semiconductor layer 13 can be etched utilizing the periodic structure of a nanoparticle 9 as a mask, to obtain the periodic structure of a nanodot 1. This will be explained below using figures.

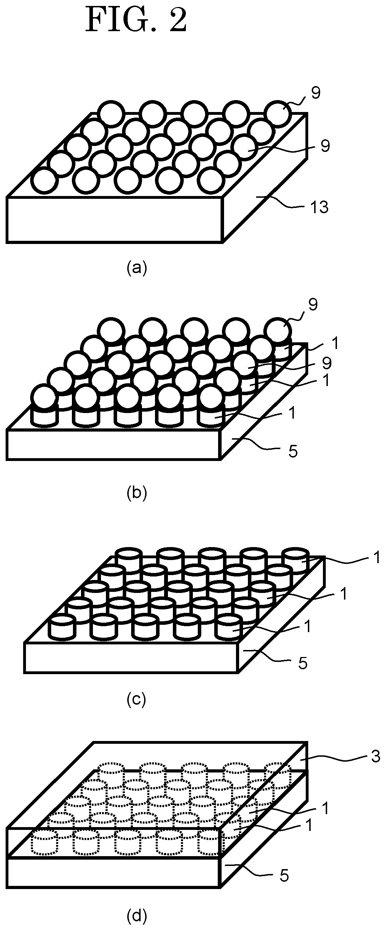

First, nanoparticles 9 are arrayed on a semiconductor layer 13 as shown in Fig. 2(a). The semiconductor layer 13 is preferably composed of a material containing silicon in an amount of 30 atom% or more, particularly of silicon since the layer 13 is a member giving nanodots later. For arraying the nanoparticles 9 on the semiconductor layer 13, a dispersion obtained by dispersing the nanoparticles 9 in a liquid can be applied on the semiconductor layer 13 and dried, to uniformly array the particles. The nanoparticle 9 is not particularly restricted providing it acts as an etching mask for the semiconductor layer 13, and organic materials such as polystyrene particles, latex particles and self-assembled polymers (DSA (Directed Self-Assembly) polymer) and inorganic materials such as silica particles and metal compound particles can be used. It is preferable that the diameter of the nanoparticle 9 is 1 nm or more and 20 nm or less, namely, when particle size distribution of the nanoparticle 9 is evaluated, the diameters of 99% particles on a number basis are in the rage of 1 nm or more and 20 nm or less. The average particle size of the nanoparticles 9 on a number basis is preferably 5 nm or more and 10 nm or less. The dispersion medium for the nanoparticle 9 can be appropriately selected, and for example, water, a water-alcohol mixed liquid and an organic solvent can be used.

The concentration of the dispersion obtained by dispersing the nanoparticles 9 varies depending on the material of the nanoparticle and the kind of the dispersion medium, and for example, when polystyrene particles are used as the nanoparticles 9, the concentration is preferably in the range of 100 mg/ml to 1 g/ml, and further, more preferably 300 mg/ml to 500 mg/ml. Further, it is also possible to add a salt into the dispersion medium for controlling the Debye length of the nanoparticle. Though the salt to be used is not restricted, it is preferably a salt not containing elements (alkali metals, alkaline earth metals) causing defects as the doping material for a semiconductor.

The application method of the dispersion obtained by dispersing the nanoparticles 9 can be selected from general application methods such as a spin coat method, a Langmuir-Blodgett (LB) method and a cast method.

Thereafter, the semiconductor layer 13 is etched utilizing the periodic structure of the nanoparticles 9 as a mask, to form columnar or spherical nanodots 1, as shown in Fig. 2(b). The etching method is not particularly restricted as long as it provides a method of selectively etching the material constituting the semiconductor layer 13 against the material constituting the nanoparticle 9, and can be selected from neutral particle beam (NB) etching, fast atomic beam etching (FAB) and remote plasma etching causing little damage on the film and capable of performing anisotropic etching of high aspect ratio. Of them, neutral particle etching is most preferred since charged particles generated in plasma are passed through carbon aperture having an opening section, thereby absorbing ultraviolet light, and further neutralized, to obtain neutral particles, and the beam energy of the neutral particles can be controlled to 100 eV or less, thus, impact of plasma and ions is scarce.

In the neutral particle etching apparatus, a plasma chamber generating charged particles is connected to a processing chamber having a stage on which the treatment target is placed. Between the processing chamber and the plasma chamber, a cathode electrode for charge-exchanging positive charged particles to convert them into neutral particles is disposed. The cathode electrode is the carbon aperture and feeds neutral particles to the processing chamber, but blocks UV and VUV generated in the plasma chamber and does not pass them to the processing chamber. The pressure in the plasma chamber is sufficiently larger than the pressure in the processing chamber, and further, the pressure in the processing chamber is such a pressure that the mean free path of a gas is not shorter than the distance between the cathode electrode and the stage.

Thereafter, the nanoparticles 9 having completed the role as a mask are removed as shown in Fig. 2(c). The method of removing the nanoparticles 9 is not particularly restricted as long as it provides a method capable of etching the nanoparticles 9 selectively against the material constituting the semiconductor layer 13, and when the nanoparticle 9 is an organic material such as a polystyrene particle, a latex particle and a DSA polymer, annealing in air or ozone and treatments using oxygen or hydrogen plasma are mentioned. In the case of an inorganic material such as a silica particle and a metal compound particle, wet etching using an inorganic acid such as hydrofluoric acid, nitric acid and hydrochloric acid and dry etching using hydrogen plasma are mentioned.

Thereafter, an embedding layer 3 is formed so as to fill the space between the nanodot 1 and the nanodot 1 as shown in Fig. 2(d). The embedding layer 3 is formed on the periodic structure of the nanodots 1 by a means such as CVD (chemical vapor deposition), PVD (physical vapor deposition) and MBE (molecular beam epitaxy). The embedding layer 3 is formed so as to fill the space between the nanodots 1. It is not necessarily required to form the embedding layer 3 over the thickness of the periodic structure of the nanodots 1, but it may be thicker than the periodic structure of the nanodots 1.

A film of silicon dioxide, silicon nitride or a metal oxide which is not easily etched as compared with the etching target film may be formed as a protective layer on the semiconductor layer 13, to protect the semiconductor layer 13 and to prevent generation of film defects in etching the semiconductor layer 13.

In the present production method, the periodic structure of the nanodots 1 can be formed at a density of $5 \times 10^{10}/cm^2$ or more, and further, it becomes possible to fill the space of the periodic structure with a material having melting point equivalent to that of the material constituting the nanodot 1.

<Other production method of thermoelectric conversion material>

As the method of periodically arraying nanoparticles, a method of arraying protein particles containing a metal, then, removing the protein, to obtain metal compound particles can also be used. This method will be explained specifically below.

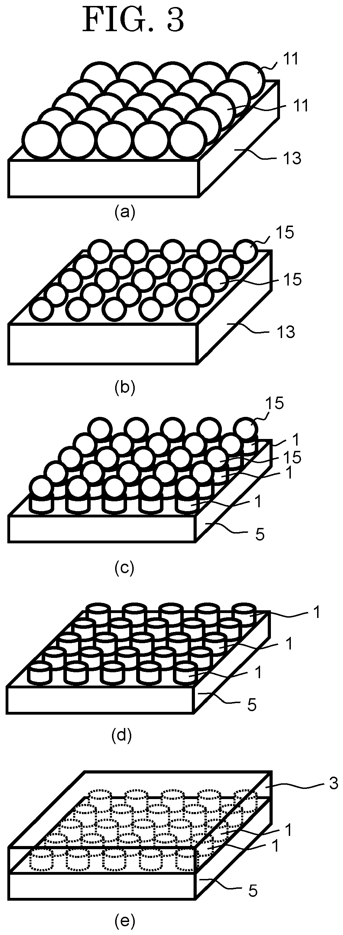

First, protein particles 11 containing a metal are arrayed on a semiconductor layer 13 as shown in Fig. 3(a). Since the size of the nanodot is determined by the size of a metal compound particle 15 generated from a metal contained in the protein particle 11, the protein particle 11 containing a metal from which the metal compound particle 15 having a diameter of 20 nm or less is obtained is used.

As the protein particle 11, ferritin as a spherical protein having iron oxide particles having a diameter of 7 nm inside the protein shell having an outer diameter of 13 nm and Listeria Dps having iron oxide particles having a diameter of 5 nm inside the protein shell having an outer diameter of 9 nm can also be used. The surface of the protein particle 11 may be modified with a polyethylene glycol chain, to prevent aggregation of particles and to regulate the interval between particles to attain easy arraying.

For arraying the protein particles 11 on the semiconductor layer 13, a dispersion obtained by dispersing the protein particles 11 in a liquid can be applied on the semiconductor layer 13 to provide uniform arraying.

The concentration of the dispersion obtained by dispersing the protein particles 11 varies depending on the material of the protein particle 11 and the dispersion medium. For example, when ferritin is used as the protein particle 11 and a 40 mM ammonium sulfate aqueous solution is used as the dispersion medium, the ferritin concentration is preferably in the range of 1 mg/ml to 500 mg/ml, and further, more preferably 1 mg/ml to 50 mg/ml. The dispersion medium for the protein particle 11 can be appropriately selected, and for example, water, a water-alcohol mixed liquid and an organic solvent can be used. Further, it is also possible to add a salt into the dispersion medium for controlling the Debye length of the nanoparticle. Though the salt to be used is not restricted, it is preferably a salt not containing elements (alkali metals, alkaline earth metals) causing defects as the doping material for a semiconductor.

Subsequently, the protein is removed from the protein particle 11, to expose the metal compound particle, as shown in Fig. 3(b). The method of removing the protein includes methods of heating under an oxygen or hydrogen atmosphere. On the semiconductor layer 13, a metal compound particle 15 derived from the protein particle 11 is generated. This metal compound particle 15 is formed at a place without shift wherein the protein particle 11 has been present. It is preferable that the diameter of the metal compound particle is 1 nm or more and 20 nm or less, namely, when particle size distribution of the metal compound particle is evaluated, the diameters of 99% particles on a number basis are in the rage of 1 nm or more and 20 nm or less. The average particle size of the metal compound particle on a number basis is preferably 5 nm or more and 10 nm or less.

Further, the semiconductor layer 13 is etched utilizing the periodic metal compound particles 15 as a mask, to form columnar or spherical nanodots 1 having a diameter of 20 nm or less having the periodic structure, as shown in Fig. 3(c).

Thereafter, the metal compound particles 15 having completed the role as a mask are removed as shown in Fig. 3(d). The method of removing the metal compound particles 15 is not particularly restricted, and for example, wet etching using a dilute hydrochloric acid aqueous solution can be used.

Further, the embedding layer 3 is formed so as to fill the space between the nanodot 1 and the nanodot 1, as shown in Fig. 3(e).

## EXAMPLES

The present invention will be further explained referring to examples and comparative examples.

<Example 1>

(a) On a Si substrate with an oxidized film, amorphous Si having a thickness of 10 nm was deposited by an electron beam deposition method. Next, it was annealed in a nitrogen atmosphere, to obtain polymerized Si.

(b) The polymerized Si was oxidized by a neutral particle beam apparatus, and a surface oxidized film ($SiO_2$) having a thickness of 3.8 nm was deposited thereon.

(c) Next, a dispersion obtained by dispersing ferritin (dispersion medium: 40 mM ammonium sulfate aqueous solution, ferritin concentration: 2.5 mg/ml) was applied on a substrate and dried, to deposit the periodic structure of ferritin on the surface oxidized film ($SiO_2$). pH of the dispersion is preferably about 8 when applied on $SiO_2$, and can be appropriately determined depending on the surface potential of the material to be applied.

(d) The shell of ferritin was removed by annealing at 400°C in an oxygen atmosphere. On $SiO_2$, the periodic structure in which particulate iron oxide cores are arrayed was deposited. The periodic structure composed of these iron oxide cores is an etching mask in the next step.

(e) First, $SiO_2$ on the surface side was etched utilizing the iron oxide cores as a mask, to remove $SiO_2$ on the surface. Next, polysilicon was removed by neutral particle beam etching utilizing the iron oxide cores as a mask.

(f) The iron oxide cores were removed by wet etching using HCl.

(g) The surface $SiO_2$ layer was removed, then, silicongermanium ($Si_{0.7}Ge_{0.3}$) having a thickness of 10 nm was deposited on Si nanodots by using MBE.

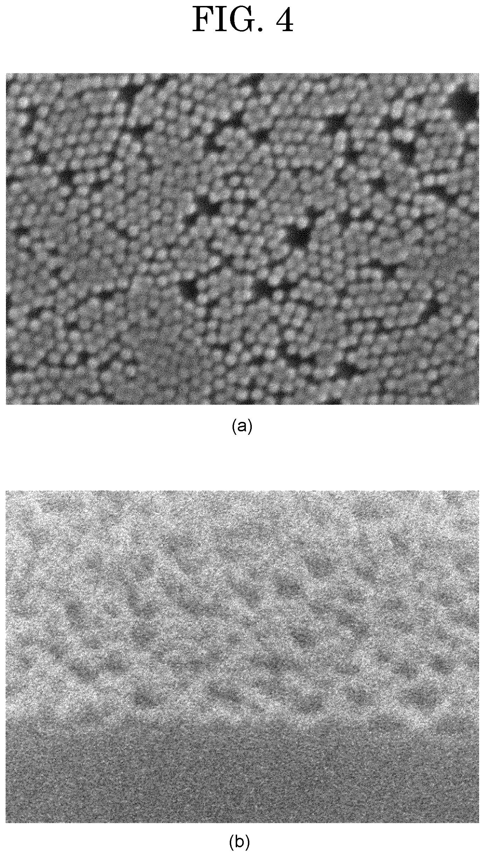

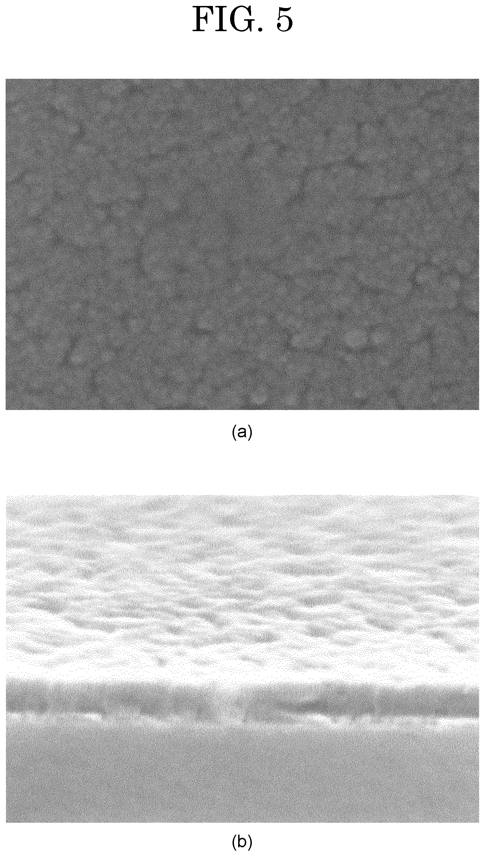

Fig. 4 is a view of a scanning electron microscopic image of the thermoelectric conversion material according to Example 1, and shows the surface of the thermoelectric conversion material after the step (f), namely, before etching and formation of the embedding layer. Fig. 4(b) shows an image tilted by 25° of the fractured section of Fig. 4(a). Fig. 5 shows the surface of the thermoelectric conversion material after the step (g), namely, after formation of the embedding layer. Fig. 5(b) shows an image tilted by 25° of the fractured section of Fig. 5(a).

According to Fig. 4, the diameters of nanodots were uniform and 10 ± 1 nm and the area density of nanodots was $7 \times 10^{11}/cm^2$, in the thermoelectric conversion material.

It is understood from Fig. 5 that the embedding layer 3 covers Si nanodots.

(Comparative Example 1)

A thermoelectric conversion material was formed in the same manner as in Example 1, excepting that silicon was used as the first material constituting nanodots and silicon carbide was used as the second material constituting the embedding layer.

(Measurement of thermoelectric conversion property)

Next, the thermoelectric conversion properties of the thermoelectric conversion materials produces in Example 1 and Comparative Example 1 and of only silicon as Comparative Example 2 were measured while changing the measuring temperature. For measurement of thermal conductivity, TCN-2ω (manufactured by ADVANCE RIKO, Inc.) was used, and for electric conductivity and Seebeck coefficient, ZEM-3 (manufactured by ADVANCE RIKO, Inc.) was used.

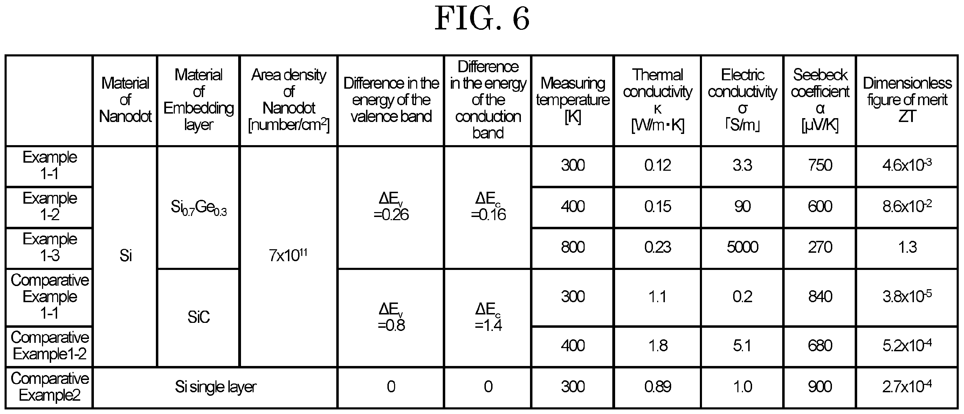

The thermoelectric conversion properties in examples and comparative examples are shown in Fig. 6.

It is understood from comparison of Example 1-1 and Comparative Example 1-1 and Comparative Example 2 or from comparison of Example 1-2 and Comparative Example 1-2 that the thermoelectric conversion material of Example 1 has lowered thermal conductivity and increased electrical conductivity, thus, has higher dimensionless figure of merit, as compared with the thermoelectric conversion material of Comparative Example 1 and the silicon single phase of Comparative Example 2 at the same measurement temperature, as shown in Fig. 6. Particularly in Example 1-3, the dimensionless figure of merit reached 1.3, that is, a numerical value higher than the dimensionless figure of merit in the optimum temperature range of BiTe-based materials which are practically used currently could be obtained.

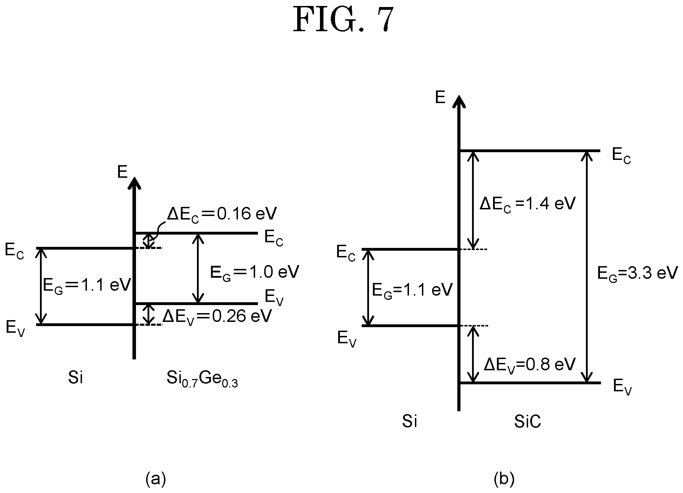

Fig. 7 shows band structures of the junction planes of Si and $Si_{0.7}Ge_{0.3}$, and Si and SiC. In Fig. 7, the energy $E_G$ of the band gap is a difference between the bottom energy level $E_C$ of the conduction band and the top energy level $E_V$ of the valence band. Between Si and $Si_{0.7}Ge_{0.3}$, $\Delta E_V$ as the difference in the energy level of the valence band is 0.26 eV and $\Delta E_C$ as the difference in the energy level of the conduction band is 0.16 eV, namely, both values are in the range of 0.1 to 0.3 eV, as shown in Fig. 7(a). In contrast, between Si and SiC, $\Delta E_V$ as the difference in the energy level of the valence band is 0.8 eV and $\Delta E_C$ as the difference in the energy level of the conduction band is 1.4 eV, namely, both values are larger than 0.3 eV, as shown in Fig. 7(b).

For the thermoelectric conversion material of Example 1, it is supposed that since silicon is made into a nanodot of 20 nm or less, phonon scattering easily occurs at the nanodot interface, and lattice thermal conductivity which is a seriously problematic in conventional silicon-based thermoelectric conversion devices can be reduced. Further, it is supposed that by filling silicongermanium between nanodots, energy filtering by potential barrier of the periodically arrayed nanodot structure is manifested and a lowering in Seebeck coefficient can be suppressed. That is, it is supposed that a high performance thermoelectric conversion material can be realized by allowing phonon scattering at the silicon nanodot interface and the energy filtering effect by potential barrier by the periodic dot structure to manifest simultaneously.

**REFERENCE SIGNS LIST**

1      nanodot,
3      embedding layer,
5      thermoelectric conversion material,
9      nanoparticle,
11     protein particle,
13     semiconductor layer,
15     metal compound particle.

**Claims**

1. A thermoelectric conversion material (5) **characterized in that** columnar or spherical nanodots (1) having a diameter of 20 nm or less are embedded in an embedding layer (3) at an area density of $5\times10^{10}/\text{cm}^2$ or more and an interval between the nanodots of 0.5 nm or more and 30.0 nm or less, and the first material constituting the nanodot is a material containing silicon in an amount of 30 atom% or more, and, either one or both of a difference in energy between the valence band of the first material and the valence band of the second material constituting the embedding layer and a difference in energy between the conduction band of the first material and the conduction band of the second material constituting the embedding layer are in the range of 0.1 eV or more and 0.3 eV or less.

2. The thermoelectric conversion material according to Claim 1, **characterized in that** the first material is silicon, and the second material is silicon-germanium in which the molar ratio of silicon to germanium is 20:80 to 80:20.

3. A production method of the thermoelectric conversion material (5) according to Claim 1, **characterized by** comprising:

   steps (A) including:

      a step of arraying nanoparticles (9) having a diameter of 1 nm or more and 20 nm or less on a semiconductor layer (13); a step of forming a columnar or spherical nanodot (1) having a diameter of 20 nm or less by etching the semiconductor layer utilizing the nanoparticles as a mask; and a step of forming an embedding layer so as to embed the nanodot, or

   steps (B) including:

      a step of arraying protein particles (11) containing a metal on a semiconductor layer (13), a step of forming a metal compound particle (15) by removing a protein from the protein particle, a step of forming a columnar or spherical nanodot having a diameter of 20 nm or less by etching the semiconductor layer utilizing the metal compound particles as a mask, a step of removing the metal compound particles, and a step of forming an embedding layer so as to embed the nanodot.

4. The production method of the thermoelectric conversion material according to Claim 3, **characterized in that** the nanoparticle is at least one selected from the group consisting of a polystyrene particle, a latex particle and a self-assembled polymer in the steps (A).

5. The production method of the thermoelectric conversion material according to Claim 3, **characterized in that** the nanoparticle is at least one selected from the group consisting of a silica particle and a metal compound particle in the steps (A).

6. The production method of the thermoelectric conversion material according to Claim 5, **characterized in that** the protein particle is at least one selected from the group consisting of ferritin and Listeria Dps in the steps (B).

7. The production method of the thermoelectric conversion material according to Claim 5, **characterized in that** the surface of the protein particle is modified with a polyethylene glycol chain in the steps (B).

**8.** The production method of the thermoelectric conversion material according to any one of Claims 3 to 7, **characterized in that** the first material constituting the semiconductor layer is silicon and the second material constituting the embedding layer is silicongermanium in which the molar ratio of silicon to germanium is 20:80 to 80:20.

**Patentansprüche**

**1.** Thermoelektrisches Konversionsmaterial (5), **dadurch gekennzeichnet, dass** säulenförmige oder sphärische Nanodots (1) mit einem Durchmesser von 20 nm oder weniger in einer Flächendichte von $5 \times 10^{10}$/cm$^2$ oder mehr und einem Abstand zwischen den Nanodots von 0,5 nm oder mehr und 30,0 nm oder weniger in einer Einbettungsschicht (3) eingebettet sind und dass das erste Material, das den Nanodot bildet, ein Material ist, das Silicium in einer Menge von 30 Atom-% oder mehr enthält, und dass die Energiedifferenz zwischen dem Valenzband des ersten Materials und dem Valenzband des zweiten Materials, die die Einbettungsschicht bilden, und/oder die Energiedifferenz zwischen dem Leitungsband des ersten Materials und dem Leitungsband des zweiten Materials, die die Einbettungsschicht bilden, im Bereich von 0,1 eV oder mehr und 0,3 eV oder weniger liegen.

**2.** Thermoelektrisches Konversionsmaterial gemäß Anspruch 1, **dadurch gekennzeichnet, dass** das erste Material Silicium ist und das zweite Material Silicium-Germanium ist, in dem das Stoffmengenverhältnis von Silicium zu Germanium 20:80 bis 80:20 beträgt.

**3.** Herstellungsverfahren für das thermoelektrische Konversionsmaterial (5) gemäß Anspruch 1, **dadurch gekennzeichnet, dass** es umfasst:

Schritte (A), umfassend:

einen Schritt des Anordnens von Nanopartikeln (9) mit einem Durchmesser von 1 nm oder mehr und 20 nm oder weniger auf einer Halbleiterschicht (13);
einen Schritt des Bildens eines säulenförmigen oder sphärischen Nanodots (1) mit einem Durchmesser von 20 nm oder weniger durch Ätzen der Halbleiterschicht unter Verwendung der Nanopartikel als Maske; und
einen Schritt des Bildens einer Einbettungsschicht, um den Nanodot einzubetten; oder

Schritte (B), umfassend:

einen Schritt des Anordnens von Proteinpartikeln (11), die ein Metall enthalten, auf einer Halbleiterschicht (13);
einen Schritt des Bildens eines Metallverbindungspartikels (15) durch Entfernen eines Proteins aus dem Proteinpartikel;
einen Schritt des Bildens eines säulenförmigen oder sphärischen Nanodots mit einem Durchmesser von 20 nm oder weniger durch Ätzen der Halbleiterschicht unter Verwendung der Metallverbindungspartikel als Maske;
einen Schritt des Entfernens der Metallverbindungspartikel; und
einen Schritt des Bildens einer Einbettungsschicht, um den Nanodot einzubetten.

**4.** Herstellungsverfahren für das thermoelektrische Konversionsmaterial gemäß Anspruch 3, **dadurch gekennzeichnet, dass** das Nanopartikel in den Schritten (A) wenigstens eines ist, das aus der Gruppe ausgewählt ist, die aus einem Polystyrolpartikel, einem Latexpartikel und einem selbstorganisierten Polymer besteht.

**5.** Herstellungsverfahren für das thermoelektrische Konversionsmaterial gemäß Anspruch 3, **dadurch gekennzeichnet, dass** das Nanopartikel in den Schritten (A) wenigstens eines ist, das aus der Gruppe ausgewählt ist, die aus einem Siliciumoxidpartikel und einem Metallverbindungspartikel besteht.

**6.** Herstellungsverfahren für das thermoelektrische Konversionsmaterial gemäß Anspruch 5, **dadurch gekennzeichnet, dass** das Proteinpartikel in den Schritten (B) wenigstens eines ist, das aus der Gruppe ausgewählt ist, die aus Ferritin und *Listeria*-Dps besteht.

**7.** Herstellungsverfahren für das thermoelektrische Konversionsmaterial gemäß Anspruch 5, **dadurch gekennzeichnet, dass** die Oberfläche des Proteinpartikels in den Schritten (B) mit einer Polyethylenglycolkette modifiziert wird.

**8.** Herstellungsverfahren für das thermoelektrische Konversionsmaterial gemäß einem der Ansprüche 3 bis 7, **dadurch gekennzeichnet, dass** das erste Material, das die Halbleiterschicht bildet, Silicium ist und das zweite Material, das die Einbettungsschicht bildet, Silicium-Germanium ist, in dem das Stoffmengenverhältnis von Silicium zu Germanium 20:80 bis 80:20 beträgt.

**Revendications**

**1.** Matériau à conversion thermoélectrique (5), **carac-**

**térisé en ce que** des nanopoints colonnaires ou sphériques (1) ayant un diamètre de 20 nm ou moins sont intégrés dans une couche d'intégration (3) avec une densité de surface de 5 x $10^{10}$/cm$^2$ ou plus et avec un écart entre les nanopoints de 0,5 nm ou plus et 30,0 nm ou moins, et

le premier matériau constituant le nanopoint est un matériau contenant du silicium dans une proportion des 30 % atomique ou plus, et la différence en énergie entre la bande de valence du premier matériau et la bande de valence du second matériau constituant la couche d'intégration, et/ou la différence en énergie entre la bande de conduction du second matériau constituant la couche d'intégration sont comprises dans la gamme de 0,1 eV ou plus et 0,3 eV ou moins.

2.  Matériau à conversion thermoélectrique selon la revendication 1, **caractérisé en ce que** le premier matériau est le silicium, et le second matériau est le silicium-germanium dans lequel le rapport molaire de silicium à germanium est de 20 : 80 à 80 : 20.

3.  Procédé de production du matériau à conversion thermoélectrique (5) selon la revendication 1, **caractérisé en ce qu'**il comprend :

    des étapes (A), comprenant
    une étape consistant à tramer des nanoparticules (9) ayant un diamètre de 1 nm ou plus et 20 nm ou moins sur une couche de semi-conducteurs (13),
    une étape consistant à former un nanopoint colonnaire ou sphérique (1) ayant un diamètre de 20 nm ou moins par la gravure de la couche de semi-conducteurs en utilisant les nanoparticules comme masque, et
    une étape consistant à former une couche d'intégration pour intégrer le nanopoint, ou
    des étapes (B), comprenant
    une étape consistant à tramer des particules de protéine (11) contenant un métal sur une couche de semi-conducteurs (13),
    une étape consistant à former une particule de composé métallique (15) en éliminant une protéine de la particule de protéine,
    une étape consistant à former un nanopoint colonnaire ou sphérique ayant un diamètre de 20 nm ou moins par la gravure de la couche de semi-conducteurs en utilisant les particules de composé métallique comme masque,
    une étape consistant à éliminer les particules de composé métallique, et
    une étape consistant à former une couche d'intégration pour intégrer le nanopoint.

4.  Procédé de production du matériau à conversion thermoélectrique selon la revendication 3, **caracté-**

**risé en ce que** la nanoparticule est au moins une choisie dans le groupe consistant en une particule de polystyrène, une particule de latex, et un polymère auto-assemblé dans les étapes (A).

5.  Procédé de production du matériau à conversion thermoélectrique selon la revendication 3, **caractérisé en ce que** la nanoparticule est au moins une choisie dans le groupe consistant en une particule de silice et une particule de composé métallique dans les étapes (A).

6.  Procédé de production du matériau à conversion thermoélectrique selon la revendication 5, **caractérisé en ce que** la particule de protéine est au moins une choisie dans le groupe consistant en ferritine et Dps de *Listéria* dans les étapes (B).

7.  Procédé de production du matériau à conversion thermoélectrique selon la revendication 5, **caractérisé en ce que** la surface de la particule de protéine est modifiée avec une chaîne de polyéthylène glycol dans les étapes (B).

8.  Procédé de production du matériau à conversion thermoélectrique selon l'une quelconque des revendications 3 à 7, **caractérisé en ce que** le premier matériau constituant la couche de semi-conducteurs est le silicium, et le second matériau constituant la couche d'intégration est le silicium-germanium dans lequel le rapport molaire de silicium à germanium est de 20 : 80 à 80 : 20.

# FIG. 1

# FIG. 2

(a)

(b)

(c)

(d)

# FIG. 3

(a)

(b)

(c)

(d)

(e)

# FIG. 4

(a)

(b)

# FIG. 5

(a)

(b)

# FIG. 6

| | Material of Nanodot | Material of Embedding layer | Area density of Nanodot [number/cm²] | Difference in the energy of the valence band | Difference in the energy of the conduction band | Measuring temperature [K] | Thermal conductivity κ [W/m·K] | Electric conductivity σ [S/m] | Seebeck coefficient α [μV/K] | Dimensionless figure of merit ZT |
|---|---|---|---|---|---|---|---|---|---|---|
| Example 1-1 | Si | $Si_{0.7}Ge_{0.3}$ | $7 \times 10^{11}$ | $\Delta E_v = 0.26$ | $\Delta E_c = 0.16$ | 300 | 0.12 | 3.3 | 750 | $4.6 \times 10^{-3}$ |
| Example 1-2 | Si | $Si_{0.7}Ge_{0.3}$ | $7 \times 10^{11}$ | $\Delta E_v = 0.26$ | $\Delta E_c = 0.16$ | 400 | 0.15 | 90 | 600 | $8.6 \times 10^{-2}$ |
| Example 1-3 | Si | $Si_{0.7}Ge_{0.3}$ | $7 \times 10^{11}$ | $\Delta E_v = 0.26$ | $\Delta E_c = 0.16$ | 800 | 0.23 | 5000 | 270 | 1.3 |
| Comparative Example 1-1 | Si | SiC | $7 \times 10^{11}$ | $\Delta E_v = 0.8$ | $\Delta E_c = 1.4$ | 300 | 1.1 | 0.2 | 840 | $3.8 \times 10^{-5}$ |
| Comparative Example 1-2 | Si | SiC | $7 \times 10^{11}$ | $\Delta E_v = 0.8$ | $\Delta E_c = 1.4$ | 400 | 1.8 | 5.1 | 680 | $5.2 \times 10^{-4}$ |
| Comparative Example 2 | Si single layer | | | 0 | 0 | 300 | 0.89 | 1.0 | 900 | $2.7 \times 10^{-4}$ |

# FIG. 7

(a)

(b)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP H11317547 B
- WO 2012173162 A
- US 2006032526 A1
- JP 2008523579 A
- JP H05251338 A
- JP 2015103609 A

**Non-patent literature cited in the description**

- **BENJAMIN. M. C. et al.** *Nano let.,* 2013, vol. 13, 5503